# EUROPEAN PATENT APPLICATION

(11) **EP 1 679 480 A1**
(43) Date of publication of application: **12.07.2006**
(21) Application number: 05028045.2
(22) Date of filing: 21.12.2005
(51) Int. Cl.: F25B 27/00, H01L 35/00

(54) **Thermoelectric generator**

(30) Priority: 22.12.2004 JP 2004372254
(71) Applicant: DENSO CORPORATION, Kariya-city, Aichi-pref. 448-8661 (JP); Toyota Jidosha Kabushiki Kaisha, Toyota-city, Aichi-pref 471-8571 (JP)
(72) Inventor: Yamaguchi, Hiroo Denso Corporation, Kariya-city Aichi-pref., 448-8661 (JP); Yamanaka, Yasutoshi Denso Corporation, Kariya-city Aichi-pref., 448-8661 (JP); Mori, Rentaro, Toyota-city Aichi-pref., 471-8571 (JP); Inaoka, Hiroya, Toyota-city Aichi-pref., 471-8571 (JP)
(74) Representative: Klingseisen, Franz

(57) **Abstract**

A thermoelectric generator (110) has a high temperature heat source part (111) provided on a first passage (23) through which a first fluid for cooling an engine (10) flows, a low temperature heat source part (112) provided on a second passage through which a second fluid having a temperature lower than that of the first fluid flows, and a thermoelectric element (113) for producing electric power by a temperature difference produced between the high temperature heat source part (111) and the low temperature heat source part (112). The first passage (23) is included in a first circuit (20) in which the engine (10) and a first radiator (21) for cooling the first fluid are connected in loop through a main passage. Further, the first passage (23) is in parallel to the first radiator (21) in the first circuit (20). The second passage is included in a second circuit (30) that is separate from the first circuit (20) and includes a second radiator (31) for cooling the second fluid.

## Description

The present invention relates to a thermoelectric generator that recovers electric energy from waste heat energy generated in an engine by using a thermoelectric element.

It is known to recover electric energy from waste heat energy generated in an internal combustion engine (hereafter, engine) by a thermoelectric element. For example, in an engine cooling water circulation system disclosed in Japanese Unexamined Patent Publication No. JP-A-10-238406, electric energy is recovered by using cooling water, which circulates in a cooling water circuit connecting an engine and a first radiator, as a high temperature heat source part of a thermoelectric element and a second radiator, which is cooled by air or water, as a low temperature heat source part of the thermoelectric element. Further, the high temperature heat source part is constructed of a tank and is connected to the first radiator in series in the cooling water circuit.

In the above system, however, a resistance to the cooling water in the cooling water circuit is increased by the high temperature heat source part. Therefore, a flow rate of the cooling water in the first radiator decreases. This results in deterioration of cooling performance. To solve this matter, for example, it is required to increase the size of the first radiator and to improve the capacity of a pump for circulating the cooling water in the circuit.

In a waste heat recovery device disclosed in Japanese Unexamined Patent Publication NO. JP-A-9-32636, a heat recovering means (thermoelectric element) is provided between a primary cooling water circuit through which a primary cooling water flows and a secondary cooling water circuit through which a secondary cooling water flows, thereby to recover electric energy by using a temperature difference produced between the primary cooling water and the secondary cooling water.

In the above device, the primary cooling water circuit includes a cooling water jacket provided on an engine body as one element of a closed circuit, and has a first cooling water pump for circulating the primary cooling water therein. On the contrary, the secondary cooling water circuit is provided separate from the primary cooling water circuit and is constructed of a radiator as one element of a closed circuit. The secondary cooling water circuit is provided with a water pump. A circulation rate of the secondary cooling water is adjusted in accordance with an engine operation condition, thereby to control the temperature of the primary cooling water through the thermal-element for cooling the engine body.

Since the temperature of the primary cooling water is controlled by the flow rate control of the secondary cooling water through the thermoelectric element, the thermoelectric element is required to increase a coefficient of thermal conductivity for this temperature control. However, if the coefficient of thermal conductivity is increased, it is difficult to sufficiently maintain the temperature difference on the surfaces of the thermoelectric element. Further, this results in deterioration of recovery efficiency (i.e. generation efficiency) on recovering electric energy (i.e. on generating electric power). On the contrary, if the coefficient of thermal conductivity of the thermoelectric element is reduced, it is required to increase the capacity of the radiator and the motive power of the water pump of the secondary cooling water circuit for cooling the engine body.

The present invention is made in view of the foregoing matter, and it is an object of the present invention to provide a thermoelectric generator capable of generating electric power through a thermoelectric element while sufficiently maintaining a capacity to cool an engine and suppressing a decrease of a flow rate of a cooling water in a radiator.

According to the present invention, a thermoelectric generator has a high temperature heat source part, a low temperature heat source part and a thermoelectric element. The high temperature heat source part is provided on a first passage through which a first fluid for cooling an engine flows for receiving heat from the first fluid. The low temperature heat source part that is provided on a second passage through which a second fluid flows for receiving heat from the second fluid. The second passage is provided separate from the first passage. The second fluid has a temperature lower than the first fluid. The thermoelectric element is provided between the high temperature heat source part and the low temperature heat source part for producing electric power by a temperature difference between the high temperature heat source part and the low temperature heat source part.

The first passage is included in a first circuit. In the first circuit, the engine and a first radiator for cooling the first fluid are connected in loop through a main passage. Further, the first passage is arranged in parallel to the first radiator. The second passage is included in a second circuit that is separate from the first circuit. The second circuit has a second radiator for cooling the second fluid.

Since the high temperature heat source part is arranged in parallel to the first radiator in the first circuit, it is less likely that the flow rate of the first fluid in the first radiator will be reduced by the high temperature heat source part. Accordingly, the first fluid is sufficiently cooled without requiring the increase of the size of the first radiator, and therefore, the engine is maintained at a predetermined temperature.

Further, it is not necessary to transfer heat of the first fluid from the high temperature heat source part to the low temperature heat source part through the thermoelectric element. Therefore, the coefficient of heat conductivity of the thermoelectric element is set at a low level. Furthermore, because the second fluid circulating in the second circuit is cooled through the second radiator, the temperature of the low temperature heat source part is maintained at a low level. Accordingly, electric energy is effectively produced by the thermoelectric element while maintaining the temperature difference between the high temperature heat source part and the low temperature heat source part at a constant level.

Other objects, features and advantages of the present invention will become more apparent from the following detailed description made with reference to the accompanying drawings, in which like parts are designated by like reference numbers and in which:
Fig. 1 is a schematic block diagram of a thermoelectric generator system according to an embodiment of the present invention;
Fig. 2 is a schematic block diagram of the thermoelectric generator system for showing a flow of engine cooling water on starting an engine according to the embodiment of the present invention; and
Fig. 3 is a schematic block diagram of the thermoelectric generator system for showing a flow of engine cooling water on cold-starting the engine according to the embodiment of the present invention.

Embodiments of the present invention will be described hereinafter with reference to the drawing.

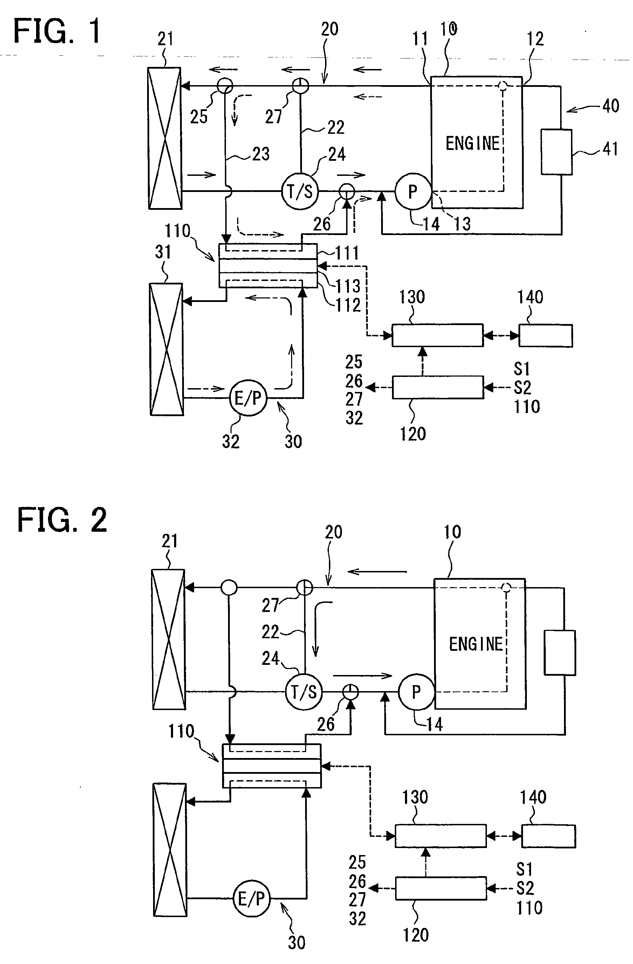

Referring to Fig. 1, a thermoelectric generator system 100 is mainly constructed of a thermoelectric generator 110 and a control device 120 for controlling operation of the thermoelectric generator 110. The thermoelectric generator system 100 is used in a vehicle having a water-cooled engine 10 for recovering electric energy from waste heat energy of the engine 10. Specifically, in the thermoelectric generator 110, electric power is produced at a thermoelectric element 113 by a temperature difference between a high temperature heat source part 111 and a low temperature heat source part 112.

First, the basic configuration of the thermoelectric generator system 100 will be described with reference to Fig. 1. The engine 10 is provided with an engine cooling water circuit (first circuit) 20. A main passage of the engine cooling water circuit 20 is constructed such that engine cooling water (first fluid) passing through the engine 10 is circulated from a first outlet portion 11 to an inlet portion 13 through an engine cooling water radiator (hereafter, referred to as a first radiator) 21 by a water pump 14. Here, the water pump 14 is located close to the inlet portion 13 and is driven by the engine 10.

Further, the engine cooling water circuit 20 is provided with a bypass passage 22 bypassing the first radiator 21, and a thermostat 24. The thermostat 24 is located at a confluence where the bypass passage 22 meets with the main passage at a position downstream of the first radiator 21. The thermostat 24 is provided to adjust a flow rate of the engine cooling water of the main passage communicating with the first radiator 21 and a flow rate of the engine cooling water of the bypass passage 22.

Specifically, the thermostat 24 closes the main passage when the temperature of engine cooling water is equal to or lower than a predetermined first temperature (e.g. 85 °C). When the temperature of engine cooling water exceeds the first predetermined temperature, the thermostat 24 begins to open the main passage. When the temperature of engine cooling water is equal to or higher than a second predetermined temperature (e.g. 90 °C), the thermostat 24 closes the bypass passage 22 and fully opens the main passage.

Further, the engine cooling water circuit 20 is provided with a parallel passage (first passage) 23 that is arranged in parallel to the first radiator 21. Specifically, the parallel passage 23 diverges from the main passage between the first radiator 21 and the bypass passage 22, at an upstream position of the first radiator 21. The parallel passage 23 meets with the main passage between the thermostat 24 and the water pump 14.

At the diverging point of the parallel passage 23, a flow rate adjustment valve 25 is provided. A flow rate of the engine cooling water to the first radiator 21 and a flow rate of the engine cooling water to the parallel passage 23 to adjusted in accordance with an opening degree of the valve 25. Further, a switching valve 26 is provided at the confluence of the parallel passage 23 and the main passage. The switching valve 26 switches the passage so that at least one of the engine cooling water flowing from the parallel passage 23 and the engine cooling water flowing through the main passage from the thermostat 24 is introduced toward the engine 10.

Furthermore, a switching valve 27 is provided at a diverging point where the bypass passage 22 diverges from the main passage of the engine cooling water circuit 20. The switching valve 27 switches the main passage and the bypass passage 22. The opening degree of the flow rate adjustment valve 25, and the switching operation of the switching valves 26, 27 are controlled by the control device 120.

Further, the thermoelectric generator system 100 has a low temperature circuit (second circuit, second passage) 30 through which low temperature cooling water (second fluid) circulates. The low temperature circuit 30 is operated separate from the engine cooling water circuit 20. On the low temperature circuit 30, a low temperature cooling water radiator (hereafter, referred to as a second radiator) 31 is provided. Further, an electric pump 32 is provided on the low temperature circuit 30 for circulating the low temperature cooling water therein. The low temperature cooling water is cooled through the second radiator 31, so the temperature of the low temperature cooling water is maintained lower than the temperature of the engine cooling water of the engine cooling water circuit 20. The electric pump 32 is controlled by the control device 120.

Also, the engine 10 is provided with a heater hot water circuit 40 through which the engine cooling water circulates. The heater hot water circuit 40 extends from a second outlet portion 12 and meets with the main passage of the engine cooling water circuit 20 at a position upstream of the water pump 14 through a heater core 41. Here, the heater core 41 is a heat exchanger that heats air for an air-conditioning system by using heat of the engine cooling water (hot water).

The thermoelectric generator 110 uses the engine cooling water of the cooling water circuit 20 and the low temperature cooling water of the low temperature side circuit 30 as the heat sources. The thermoelectric generator 110 is constructed of the high temperature heat source part 111, the low temperature heat source part 112, and the thermoelectric element 113.

The thermoelectric element (thermoelectric module) 113 is a known element that produces electric power by Seebeck effect and generates heat by Peltier effect. The thermoelectric element 113 is constructed by alternately arranging p-type semiconductors and n-type semiconductors in series through metal electrodes.

Each of the high temperature heat source part 111 and the low temperature heat source part 112 is provided as a heat exchanger and constructed of a metallic container device having a flat shape. Further, inner fins are inserted therein. The high temperature heat source part 111 and the low temperature heat source part 112 are closely attached to a first side and a second side of the thermoelectric element 113, respectively. Between the thermoelectric element 113 and the high temperature side heat source 111 and between the thermoelectric element 113 and the low temperature side heat source 112, electrical insulators are sandwiched and thermal conductive grease is applied for reducing contact heat resistance. Alternatively, heat-transfer sheets are sandwiched between them.

The high temperature heat source part 111 is arranged on the parallel passage 23, so that the engine cooling water of the engine cooling water circuit 20 passes through the high temperature heat source part 111. Similarly, the low temperature side heat source part 112 is arranged on the low temperature side circuit 30, so that the low temperature cooling water of the low temperature side circuit 30 passes through the low temperature heat source part 112. That is, the thermoelectric generator 110 is constructed such that the thermoelectric element 113 uses the engine cooling water flowing through the parallel passage 23 and the low temperature cooling water flowing through the low temperature side circuit 30 as a high temperature side heat source and a low temperature side heat source, respectively.

The control device (control means) 120 receives signals such as an outside air temperature signal and a cooling water temperature signal from an outside air temperature sensor S1 and an engine cooling water sensor S2, respectively. Also, the control device 120 receives an operation condition of the thermoelectric generator 110. The control device 120 controls the flow rate adjustment valve 25, the switching valves 26, 27 and the electric pump 32 based on the above information.

Further, the control device 120 controls an inverter (power converting device) 130. Specifically, when the electric power is produced by the thermoelectric element 113, the generated electric power is stored in a battery 140 through the inverter 130. Also, the electric power is sent to the thermoelectric element 113 from the battery 140 through the inverter 130 in accordance with the outside temperature signal and the cooling water temperature signal. Here, the control device 120, the inverter 130 and the battery 140 provide an electric power supply means (electric power supply unit).

Next, operation and advantageous effects of the above configuration will be described with reference to Figs. 1 to 3.

### 1. During normal operation of the engine 10

During the operation of the engine 10, when the temperature of the engine cooling water in the engine cooling water circuit 20 exceeds the first predetermined temperature (e.g. 85 °C), the thermostat 24 closes the bypass passage 22 and opens the main passage communicating with the first radiator 21. At this time, the switching valve 26 is controlled such that both the main passage from the thermostat 24 and the parallel passage 23 communicate with the water pump 14, as shown in Fig. 1. Further, the switching valve 27 is controlled to open the main passage so that the engine cooling water flows to the first radiator 21. Furthermore, the electric pump 32 of the low temperature side circuit 30 is operated.

Thus, in the engine cooling water circuit 20, the engine cooling water diverges into the main passage for passing through the first radiator 21 (solid line arrow in Fig. 1) and the parallel passage 23 for returning to the main passage while bypassing the first radiator 21 (broken-line arrow in Fig. 1). Also, the low temperature cooling water of the low temperature side circuit 30 circulates through the second radiator 31 (dashed-line arrow in Fig. 1). Further, the engine cooling water passes through the high temperature heat source part 111, and the low temperature cooling water passes through the low temperature heat source part 112.

Accordingly, the engine cooling water is cooled through the radiator 21, and therefore, the temperature of the engine 10 is maintained at a predetermined level. Also, a constant temperature difference is produced between the heat source parts 111, 112 by the engine cooling water and the low temperature cooling water. Therefore, the thermoelectric element 113 produces electric power by Seebeck effect. At this time, the inverter 130 is operated so that the produced electric power is stored in the battery 140.

Here, the opening degree of the flow rate adjustment valve 25 is controlled in accordance with the temperature of the engine cooling water, thereby to control the amount of electric power to be generated. Namely, when a cooling power required to the first radiator 21 is large, that is, when the temperature of the engine cooling water is high, the flow rate to the first radiator 21 is increased. On the contrary, when the cooling power required to the first radiator 21 is small, that is, when the temperature of the engine cooling water is low, the flow rate to the parallel passage 23 is increased. Accordingly, the amount of electric power generated in the thermoelectric element 113 is increased. 2. On starting up the engine 10

On starting up the engine 10, when both the temperature signals from the outside air temperature sensor S1 and the engine water temperature sensor S2 are higher than 10 °C, the thermostat 24 opens the bypass passage 22 and closes the main passage from the first radiator 21. At this time, the switching valve 26 is controlled to open only the main passage so that the thermostat 24 communicates with the water pump 14, as shown in Fig. 2. Also, the switching valve 27 is controlled to open the bypass passage 22. Furthermore, the electric pump 32 of the low temperature side circuit 30 is stopped.

Thus, the engine cooling water only flows through the bypass passage 22 (solid line arrow in Fig. 2), thereby to warm up the engine 10. This operation corresponds to a normal warming operation by the bypass passage 22. At this time, the electric power is not produced from the thermoelectric element 113.

### 3. On cold-starting of the engine 10

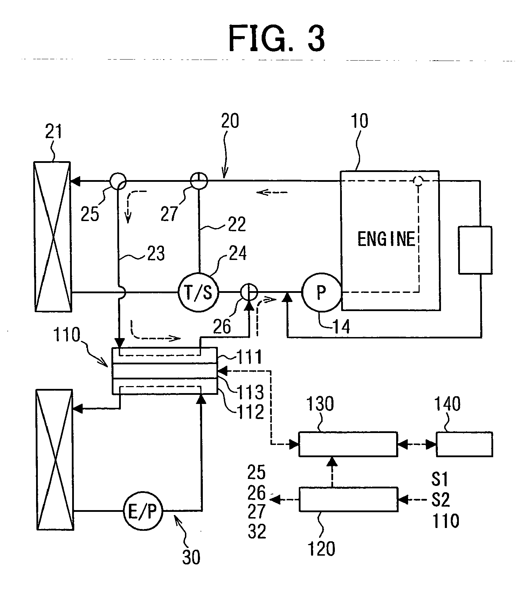

On cold-starting the engine 10, when both of the temperature signals from the outside air temperature sensor S1 and the engine water temperature sensor S2 are equal to or lower than 10 °C, the thermostat 24 opens the bypass passage 22 and closes the main passage from the radiator 21. At this time, the switching valve 26 is controlled to open only the parallel passage 23, as shown in Fig. 3. Also, the switching valve 27 is controlled to open the main passage and close the bypass passage 22. Furthermore, the opening degree of the flow rate adjustment valve 25 is controlled so that the parallel passage 23 is fully open and the main passage to the first radiator 21 is fully closed. The inverter 130 is controlled to introduce the electric power from the battery 140 to the thermoelectric element 113. That is, the thermoelectric element 113 is supplied with the electric power. Here, the electric pump 32 of the low temperature side circuit 30 is stopped.

Thus, the cooling water in the engine cooling water circuit 20 flows through the parallel passage 23 and the high temperature side heat source 111, and then returns to the engine 10 (broken line arrow in Fig. 3). Particularly, the cooling water is heated while flowing through the high temperature heat source part 111 by Peltier effect of the thermoelectric element 113. Therefore, the warming of the engine 10 is facilitated.

Accordingly, the high temperature heat source part 111 is arranged in parallel to the radiator 21 in the engine cooling water circuit 20. Therefore, it is less likely that the flow rate of the engine cooling water in the radiator 21 is decreased by the high temperature heat source part 111. Further, the engine cooling water is sufficiently cooled by the first radiator 21 without requiring an increase of the size of first radiator 21 and an increase of capacity of the water pump 14. Furthermore, the temperature of the engine 10 is maintained at a predetermined level.

Because it is not necessary to transfer heat from the high temperature heat source part 111 to the low temperature side heat source 112 through the thermoelectric element 113, the coefficient of thermal conductivity of the thermoelectric element 113 is set at a low level. Further, the low temperature cooling water of the low temperature side circuit 30 is cooled through the second radiator 31. Therefore, the temperature of the low temperature heat source part 112 is constantly maintained at a low level. With this, the constant temperature difference is maintained between the high temperature heat source part 111 and the low temperature heat source part 112. Accordingly, the electric power is effectively produced by the thermoelectric element 113.

During the normal operation of the engine 10, the flow rate of the engine cooling water to the first radiator 21 and the flow rate of the parallel passage 23 are adjusted by the flow rate adjustment valve 25 in accordance with the cooling power required to the first radiator 21, that is, in accordance with the temperature of the engine cooling water. Accordingly, the electric power is produced through the thermoelectric element 113 by effectively using the waste heat of the engine 10.

Further, on the engine cold-starting, the thermoelectric element 113 is supplied with the electric power and the cooling water passing through the high temperature heat source part 111 is heated by Peltier effect of the thermoelectric element 113. Accordingly, the warming of the engine 10 is facilitated. With this, friction loss is decreased and emission characteristic is improved. Furthermore, the fuel economy of the engine 10 is enhanced.

The above embodiment is for example modified as follows. First, in a case that the heating control of the cooling water by Peltier effect of the thermoelectric element 113 is not required during the cold starting, the position of the confluence of the parallel passage 23 to the main passage of the engine cooling water circuit 20 is changed to a position upstream of the thermostat 24. In this case, the switching valves 26, 27 are not required. (Modification 1).

In the above modification 1, in a case that the control of the electric power generation of the thermoelectric element 113 by the flow rate adjustment valve 25 is not required during the normal operation, the flow rate to the radiator 21 and the flow rate to the parallel passage 23 are fixed to predetermined values. Thus, the flow rate adjustment valve 25 is not required. (Modification 2).

The present invention is not limited to the above embodiments, but may be implemented in other ways without departing from the spirit of the invention.

## Claims

1. A thermoelectric generator (110) for recovering electric power from waste heat generated from an engine (10), the thermoelectric generator (110) comprising:
a high temperature heat source part (111) provided on a first passage (23) through which a first fluid for cooling the engine (10) flows for receiving heat from the first fluid;
a low temperature heat source part (112) provided on a second passage that is separate from the first passage (23) for receiving heat from a second fluid flowing through the second passage, the second fluid having a temperature lower than that of the first fluid; and
a thermoelectric element (113) located between the high temperature heat source part (111) and the low temperature heat source part (112) for producing electric power by a temperature difference between the high temperature heat source part (111) and the low temperature heat source part (112), wherein
the first passage (23) is included in a first circuit (20) that connects the engine (10) and a first radiator (21) for cooling the first fluid in a loop through a main passage,
the first passage (23) is disposed in parallel to the first radiator (21) in the first circuit (20), and
the second passage is included in a second circuit (30) that is separate from the first circuit and has a second radiator (31) for cooling the second fluid.

2. The thermoelectric generator (110) according to claim 1, further comprising:
a flow rate adjustment valve (25) that is located at a point where the first passage (23) diverges from the main passage for adjusting a flow rate of the first fluid to the first passage (23) and a flow rate of the first fluid to the radiator (21).

3. The thermoelectric generator (110) according to claim 2, further comprising:
a control means (120) for controlling an opening degree of the flow rate adjustment valve (25).

4. The thermoelectric generator (110) according to claim 2 or 3, wherein the flow rate adjustment valve (25) is controlled in accordance with a temperature of the first fluid.

5. The thermoelectric generator (110) according to any one of claims 1 to 4, further comprising:
an electric power supply means (120, 130, 140) for supplying electric power to the thermoelectric element (113), thereby heating the first fluid flowing through the first passage (23).
